(19) 

Europäisches
Patentamt
European
Patent Office
Office européen
des brevets

(11)  **EP 1 860 930 A1**

(12)  **EUROPEAN PATENT APPLICATION**
published in accordance with Art. 158(3) EPC

(43) Date of publication:
   **28.11.2007  Bulletin 2007/48**

(51) Int Cl.:
   ***H05K 9/00*** *(2006.01)*  ***B32B 9/00*** *(2006.01)*
   ***G09F 9/00*** *(2006.01)*

(21) Application number: **06714458.4**

(22) Date of filing: **23.02.2006**

(86) International application number:
   **PCT/JP2006/303318**

(87) International publication number:
   **WO 2006/090798 (31.08.2006 Gazette 2006/35)**

(84) Designated Contracting States:
   **AT BE BG CH CY CZ DE DK EE ES FI FR GB GR
   HU IE IS IT LI LT LU LV MC NL PL PT RO SE SI
   SK TR**

(30) Priority: **25.02.2005  JP 2005050720**

(71) Applicant: **Asahi Glass Company, Limited
   Chiyoda-ku, Tokyo 100-8405 (JP)**

(72) Inventors:
   • **MORIMOTO, Tamotsu
      chihara-shi Chiba, 2908566 (JP)**

   • **KAWASAKI, Masato
      chihara-shi Chiba, 2908566 (JP)**
   • **FUSEN, Masahiro
      chihara-shi Chiba, 2908566 (JP)**
   • **YANAGISAWA, Tohru
      1-chome, Chiyoda-ku, Tokyo, 1008405 (JP)**

(74) Representative: **Müller-Boré & Partner
   Patentanwälte
   Grafinger Strasse 2
   81671 München (DE)**

(54)  **ELECTROMAGNETIC SHIELDING LAMINATE AND DISPLAY USING SAME**

(57)   To provide an electromagnetic wave shielding laminate having a high visible light transmittance and having a low resistance and a high moisture resistance available at a low cost, and a display device using it.

   An electromagnetic wave shielding laminate 1 comprising a transparent substrate 2 and an electromagnetic wave shielding film 100 formed on the substrate, wherein the electromagnetic wave shielding film 100 has, sequentially from the substrate 2 side, a first high refractive index layer 31 made of a metal oxide having a refractive index of at least 2.0, a first oxide layer 32 containing zinc oxide and titanium oxide as the main components, an electroconductive layer 33 containing silver as the main component and a second high refractive index layer 35 made of a metal oxide having a refractive index of at least 2.0.

Fig. 1

EP 1 860 930 A1

**Description**

TECHNICAL FIELD

The present invention relates to an electromagnetic wave shielding laminate having a plurality of layers laminated on a substrate and a display device comprising the electromagnetic wave shielding laminate.

BACKGROUND ART

Electromagnetic waves are emitted from a luminescent screen of a plasma display panel (PDP). Such electromagnetic waves are influential over electronic equipment located nearby to cause malfunction thereof. Therefore, for the purpose of shielding such electromagnetic waves, it has heretofore been known to install on the front surface of the luminescent screen one having a transparent electroconductive film (electromagnetic wave shielding film) covered on a substrate of e.g. glass.

Further, the following laminates (1) to (3) have been proposed. (1) A laminate having an oxide layer containing zinc oxide containing at least one metal as the main component and a metal layer containing silver as the main component alternately laminated from the substrate side in a total layer number of 2n+1 (wherein n is a positive integer) (Patent Document 1); (2) a laminate having an oxide layer made of titanium oxide and a metal layer containing silver as the main component alternately laminated from the substrate side (Patent Document 2); and (3) a laminate having an oxide layer made of niobium oxide, a metal layer containing silver as the main component, an oxide layer made of indium oxide/tin oxide, a metal layer containing silver as the main component and an oxide layer made of niobium oxide laminated sequentially from the substrate side (Patent Document 3).

Such an electromagnetic wave shielding film is usually required to have a high visible light transmittance and a low resistance. Regarding an electromagnetic wave shielding film having oxide layers and metal layers alternately laminated, it has been known to increase the number of lamination of the metal layers or to increase the thickness of the metal layer so as to decrease the resistance.

> Patent Document 1: WO98/1385
> Patent Document 2: JP-A-2000-246831
> Patent Document 3: Korean Patent Publication No. 2003-93734

DISCLOSURE OF THE INVENTION

OBJECT TO BE ACCOMPLISHED BY THE INVENTION

In the method as disclosed in Patent Document 1, palladium is added to silver to improve the moisture resistance of the silver in the metal layer, whereby the resistance increases. Further, the visible light transmittance decreases when the number of lamination of the metal layers is increased so as to decrease the resistance.

Further, in the methods as disclosed in Patent Documents 2 and 3, titanium oxide or niobium oxide which is a material having a high refractive index is used for the oxide layer. Use of a material having a high refractive index such as titanium oxide or niobium oxide brings such an advantage that the decrease in the transmittance is small even if the lamination number is increased. However, a laminate wherein titanium oxide or niobium oxide is in direct contact with silver is poor in moisture resistance. The moisture resistance will improve by addition of palladium to silver, but the resistance will increase.

Under these circumstances, it is an object of the present invention to provide an electromagnetic wave shielding laminate having a high visible light transmittance and having a low resistance and a high moisture resistance available at a low cost, and a display device using it.

MEANS TO.ACCOMPLISH THE OBJECT

The electromagnetic wave shielding laminate of the present invention is an electromagnetic wave shielding laminate comprising a transparent substrate and an electromagnetic wave shielding film formed on the substrate, wherein the electromagnetic wave shielding film has; sequentially from the substrate side, a first high refractive index layer made of a metal oxide having a refractive index of at least 2.0, a first oxide layer containing zinc oxide and titanium oxide as the main components, an electroconductive layer containing silver as the main component and a second high refractive index layer made of a metal oxide having a refractive index of at least 2.0.

The electromagnetic wave shielding film preferably has a second oxide layer between the electroconductive layer and the second high refractive index layer.

The second oxide layer is preferably a layer containing zinc oxide as the main component, a layer containing indium oxide and tin oxide as the main components, a layer containing indium oxide and cerium oxide as the main components, or a layer containing tin oxide as the main component.

At least one of the first and second high refractive index layers is preferably a layer containing niobium oxide or titanium oxide as the main component.

The electroconductive layer is preferably a layer made of a silver alloy containing gold and/or bismuth or a layer made of a simple substance of silver.

At least three such electromagnetic wave shielding films are preferably laminated from the substrate side.

According to another embodiment of the present invention, the electromagnetic wave shielding laminate is an electromagnetic wave shielding laminate comprising a transparent substrate and at least two electromagnetic wave shielding films laminated on the substrate, wherein each of the electromagnetic wave shielding films has, sequentially from the substrate side, a first high refractive index layer made of a metal oxide having a refractive index of at least 2.0, a first oxide layer containing zinc oxide and titanium oxide as the main components, an electroconductive layer containing silver as the main component and a second high refractive index layer made of a metal oxide having a refractive index of at least 2.0, the first high refractive index layer and the second high refractive index-layer have the same composition, and the first high refractive index layer and the second high refractive index layer in direct contact with each other of adjacent electromagnetic wave shielding films form a single uniform layer.

Each of the electromagnetic wave shielding films preferably has a second oxide layer between the electroconductive layer and the second high refractive index layer.

At least one of the first and second high refractive index layers is preferably a layer containing niobium oxide or titanium oxide as the main component.

The display device of the present invention comprises a display screen to display images and the electromagnetic wave shielding laminate of the present invention provided on the observer side of the display screen.

EFFECTS OF THE INVENTION

The electromagnetic wave shielding laminate and the display device of the present invention are an electromagnetic wave shielding laminate having a high visible light transmittance and having a low resistance and a high moisture resistance available at a low cost and a display device using it.

DETAILED DESCRIPTION OF THE DRAWINGS.

Fig. 1 is a cross-section schematically illustrating one example of the electromagnetic wave shielding laminate of the present invention.
Fig. 2 is a cross-section schematically illustrating one example of a protective plate for a plasma display panel.
Fig. 3 is a graph illustrating transmission spectra of protective plates for a plasma display panel in Examples 1 and 2 and Comparative Example 1.

MEANINGS OF SYMBOLS

1: Electromagnetic wave shielding laminate, 2: substrate, 30: color ceramic layer, 31: first high refractive index layer, 32: first oxide layer, 33: electroconductive layer, 34: second oxide layer, 35: second high refractive index layer; 40: shatterproof film, 50: electrode, 60: protective film, 70: adhesive layer, 100: electromagnetic wave shielding film, 200: high refractive index layer formed all at once

BEST MODE FOR CARRYING OUT THE INVENTION

(ELECTROMAGNETIC WAVE SHIELDING LAMINATE)

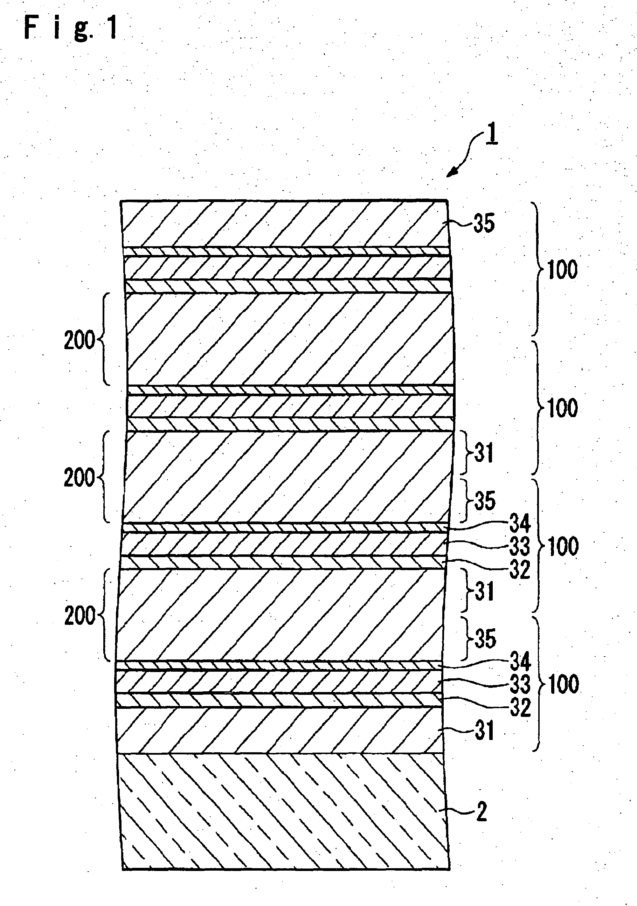

Fig. 1 is a cross-section schematically illustrating one example of the electromagnetic wave shielding laminate of the present invention. The dimensional ratio of the respective layers in the electromagnetic wave shielding laminate 1 in Fig. 1 is different from practical one in convenience in description. The electromagnetic wave shielding laminate 1 comprises a transparent substrate 2 and electromagnetic wave shielding films 100 provided on the substrate. In this embodiment, four electromagnetic wave shielding films 100 are laminated.

(Substrate)

A material of the substrate 2 is not limited so long as it is smooth and transparent, and is transparent to visible light. It may, for example, be a plastic or glass.

The plastic may, for example, be polyethylene terephthalate, polycarbonate, triacetyl cellulose, polyether sulfone or polymethyl methacrylate.

The thickness of the substrate 2 is properly determined depending upon the purpose of use. For example, the substrate 2 may be a film or may be a plate. Further, the substrate 2 may consist of a single layer or may be a laminate of a plurality of layers.

The substrate 2 may be bonded to another glass plate or plastic plate by e.g. an adhesive. For example, a plastic substrate 2 in a thin film form may be bonded to another plastic plate, glass plate or the like, or a glass plate as the substrate 2 may be bonded to another glass plate, plastic plate or the like.

(Electromagnetic Wave Shielding Film)

Each of electromagnetic wave shielding films 100 provided on the substrate 2 basically comprises a first high refractive index layer 31, a first oxide layer 32 provided on the first high refractive index layer 31, an electroconductive layer 33 provided on the first oxide layer 32, and a second high refractive index layer 35 provided on the electroconductive layer 33. In the present embodiment, a second oxide layer 34 is further provided between the electroconductive layer 33 and the second high refractive index layer 35, and each of the electromagnetic wave shielding films 100 is constituted by the first high refractive index layer 31, the first oxide layer 32, the electroconductive layer 33, the second oxide layer 34 and the second high refractive index layer 35.

(High Refractive Index Layer)

Each of the first high refractive index layer 31 and the second high refractive index layer 35 is made of a metal oxide having a refractive index of at least 2.0. The refractive index is preferably at least 2.0 and at most 2.7. By setting the refractive indices of the first high refractive index layer 31 and the second high refractive index layer 35 be at least 2.0, the visible light transmittance can be maintained high even if the number of lamination of the electromagnetic wave shielding films 100 is increased. In the present specification, the refractive index (n) is a refractive index at a wavelength of 550 nm.

A material of each of the first high refractive index layer 31 and the second high refractive index layer 35 may, for example, be niobium oxide (n: 2.35), titanium oxide (n: 2.45) or tantalum oxide (n: 2.1 to 2.2). Among them, niobium oxide or titanium oxide is preferred, and niobium oxide is more preferred. By the first high refractive index layer 31 or the second high refractive index layer 35 being a layer containing niobium oxide or titanium oxide as the main component, the amount of water penetration will be reduced, and the moisture resistance of the electromagnetic wave shielding films 100 will be improved. Particularly, the first high refractive index layer 31 or the second high refractive index layer 35 is preferably a layer containing niobium oxide as the main component, with a view to improving moisture resistance. More preferably both the first high refractive index layer 31 and the second high refractive index layer 35 are layers containing niobium oxide as the main component. The first high refractive index layer 31 preferably containing niobium oxide or titanium oxide in an amount of at least 90 mass% in the layer (100 mass%), and more preferably it substantially consists of niobium oxide or titanium oxide. The second high refractive index layer 35 preferably contains niobium oxide or titanium oxide in an amount of at least 90 mass% in the layer (100 mass%), more preferably it substantially consists of niobium oxide or titanium oxide. Further, the first high refractive index layer and the second high refractive index layer preferably have the same composition. In a case where the first high refractive index layer and the second high refractive index layer have the same composition, the first high refractive index layer and the second high refractive index layer adjacent to each other may form a single uniform layer.

Further, the first high refractive index layer 31 or the second high refractive index .layer 35 may be crystalline or amorphous, but is preferably amorphous. When the first high refractive index layer 31 or the second high refractive index layer 35 is amorphous, the following is conceivable, although it is not necessarily clear.

When the first high refractive index layer 31 or the second high refractive index layer 35 is amorphous, penetration of water via grain boundaries will reduce, whereby moisture resistance of the electromagnetic wave shielding films 100 will further improve.

Further, when the first high refractive index layer 31 is amorphous, the grain size of the compound constituting the first oxide layer 32 (a material containing zinc oxide and titanium oxide as the main components) to be formed on the first high refractive index layer 31 can be made small. When the grain size of the compound constituting the first oxide layer 32 is small, the grain size of the material (silver) constituting the electroconductive layer 33 to be formed on the first oxide layer 32 can be made small. As the grain size of the compound constituting the electroconductive layer 33 is made small, the area of contact among grain boundaries will be large. As a result, the resistance of the electroconductive layer 33 can be reduced.

The physical thickness of the first high refractive index layer 31 is preferably from 20 to 50 nm, more preferably from 30 to 40 nm. Further, the physical thickness of the second high refractive index layer 35 is preferably from 20 to 50 nm, more preferably from 30 to 40 nm.

In this embodiment, four electromagnetic wave shielding films 100 are laminated on the transparent substrate 2. Accordingly, the first high refractive index layer 31 in the second electromagnetic wave shielding film 100 is directly laminated on the second high refractive index layer 35 in the first electromagnetic wave shielding film 100. In such a case, the second high refractive index layer 35 and the first high refractive index layer 31 preferably have the same composition. In Fig. 1, the second high refractive index layer 35 and the first high refractive index layer 31 adjacent to each other is represented as a high refractive index layer 200 which is a single uniform layer. In a case where the second high refractive index layer and the first high refractive index layer adjacent to each other is a single uniform layer, the second high refractive index layer and the first high refractive index layer are represented as the high refractive index layer 200 formed all at once. Further, as the case requires, the first high refractive index layer 31 and the second high refractive index layer 35 may be formed in two or more steps.

The thickness of each of the first high refractive index layer 31 in the first film and the second high refractive index layer 35 in the last film is preferably smaller (about 1/2) than the thickness of the high refractive index layer 200, with a view to reducing the visible light reflectance and broadening the wavelength range in which a low reflectance is obtained. Further, the thicknesses of the respective layers are properly adjusted so as to adjust optical properties of the entire electromagnetic wave shielding laminate including the substrate.' In a case where at least two electromagnetic wave shielding films 100 are laminated, the thicknesses of the first high refractive index layers 31 in the respective electromagnetic wave shielding films 100 laminated may be all the same. Further, as the case requires, a high refractive index layer 35 differing in the thickness from the other first high refractive index layers 31 may be included. Similar to the case of the first high refractive index layers 31, the thicknesses of all the second high refractive index layers 35 may be the same, or a second high refractive index layer 35 differing in the thickness may be included.

A method of forming the first high refractive index layer 31 and the second high refractive index layer 35 may, for example, be a formation method by sputtering using a reducing target of a metal oxide (non-stoichiometric target), ion plating, vapor deposition or CVD. Among them, a formation method by sputtering using a reducing target of niobium oxide is advantageous with a view to preventing oxidation of the electroconductive layer 33 in formation of a niobium oxide layer on the electroconductive layer 33 and forming a layer uniformly over a large area at a high rate.

The reducing target of niobium oxide is a target which is deficient in oxygen relative to the stoichiometric composition of niobium oxide. Specifically, it is one having a composition represented by the formula $Nb_2O_x$ ($0<X<5$), and is more preferably one having electrical conductivity and is capable of discharge and film deposition by DC sputtering. Further, it is possible to employ a method of sputtering using metal niobium as a target in an oxygen atmosphere.

In the case of using a reducing target, it is preferred to use, as a sputtering gas, an inert gas containing 2 to 20 vol% of an oxidizing gas. The oxidizing gas may, for example, be an oxygen gas, nitrogen monoxide, nitrogen dioxide, carbon monoxide, carbon dioxide or ozone, and usually an oxygen gas is used.

(First Oxide Layer)

The first oxide layer 32 is a layer containing zinc oxide and titanium oxide as the main components. The first oxide layer 32 preferably contains zinc oxide and titanium oxide in a total amount of 80 mass% in the layer (100 mass%), more preferably in an amount of at least 90 mass%, and furthermore preferably, it substantially consists of zinc oxide and titanium oxide alone. Another component in the first oxide layer 32 may be a composite oxide of zinc and titanium.

Since the material containing zinc oxide and titanium oxide as the main components has a crystal structure close to the crystal structure of silver constituting the electroconductive layer 33, the following is conceivable. By the first oxide layer 32 being a layer containing zinc oxide and titanium oxide as the main components, the adhesion between the first oxide layer 32 and the electroconductive layer 33 can be maintained, whereby migration of silver will be suppressed, as compared with the case of forming the electroconductive layer 33 directly on a layer made of niobium oxide for example. By maintaining the adhesion, it is possible to prevent penetration of moisture into the interface whereby the moisture resistance of silver will be good. When the electromagnetic wave shielding film 100 in the present invention contains the second oxide layer 34 (made of a material containing zinc oxide as the main component), the adhesion can similarly be maintained at the interface between the electroconductive layer 33 made of silver having good crystallinity and the second oxide layer 34 (made of a material containing zinc oxide as the main component), whereby the moisture resistance will further be improved. Migration of silver means that silver will be diffused and agglomerated. If silver is agglomerated, the moisture resistance will be poor, and at the same time, the agglomerated portion will be whitened to show a poor outer appearance.

The amount of titanium in the first oxide layer 32 is preferably from 1 to 50 at%, more preferably from 5 to 20 at% in the total amount (100 at%) of titanium and zinc. When the amount of titanium is within this range, an electroconductive layer 33 having a low resistance and having a favorable moisture resistance will be obtained.

The physical thickness of the first oxide layer 32 is preferably from 1 to 30 nm, more preferably from 5 to 20 nm. When the physical thickness of the first oxide layer 32 is at most 30 nm, the effect of the adjacent first high refractive index layer 31 will not be impaired.

In a case where at least two electromagnetic wave shielding films 100 are laminated, the thicknesses of the first oxide layers 32 in the respective electromagnetic wave shielding films 100 laminated may be all the same. Further, as the case requires, a second oxide layer'34 differing in the thickness from the other second oxide layers 34 may be included.

A method of forming the first oxide layer 32 may, for example, be physical vapor deposition such as vacuum vapor deposition, reactive vapor deposition, ion beam assisted vapor deposition, sputtering or ion plating, or chemical vapor deposition such as plasma enhanced CVD. Among them, DC sputtering is preferred, since control of the film thickness is thereby relatively easy, a practical film strength can be obtained even when it is formed on a low temperature substrate, a film formation over a large area is easy, or formation of a laminated film is easy if a so-called inline installation is employed.

(Second Oxide Layer)

The second oxide layer 34 is a layer containing a metal oxide as the main component. The second oxide layer 34 preferably contains a metal oxide in an amount of at least 50 mass%, more preferably at least 80 mass%, furthermore preferably at least 9.0 mass% in the layer (100 mass%). It may be a layer substantially consisting of a metal oxide. The metal oxide may, for example, be preferably a material containing zinc oxide as the main component, a material containing titanium oxide as the main component, or a material containing indium oxide as the main component. In a case where the second oxide layer 34 is a layer containing zinc oxide as the main component; similar to the case of the interface between the first oxide layer 32 and the.electroconductive layer 33 made of silver, the adhesion will be maintained at the interface between the electroconductive layer 33 made of silver having good crystallinity and the second oxide layer 34 containing zinc oxide as the main component, whereby the favorable moisture resistance will further be improved.

The material of the second oxide layer 34 is more preferably a material containing titanium oxide and zinc oxide as the main components and containing titanium oxide (hereinafter referred to as TZO), a material containing zinc oxide as the main component and containing aluminum oxide (hereinafter referred to as AZO), a material containing zinc oxide as the main component and containing gallium oxide (hereinafter referred to as GZO) or a material containing indium oxide as the main component and containing tin oxide ($SnO_2$) (hereinafter referred to as ITO). Among them, TZO, AZO or GZO is preferred in view of durability of the oxide layer, and TZO or AZO is particularly preferred, which has a crystal structure closer to that of silver.

In a case where the second oxide layer 34 is made of TZO, the amount of titanium in the second oxide layer 32 is preferably from 1 to 50 at%, more preferably from 5 to 20 at% based on the total amount (100 at%) of titanium and zinc.

In a case where the second oxide layer 34 is made of AZO, the amount of aluminum in the second oxide layer 34 is preferably from 1 to 10 at%, more preferably from 2 to 6 at% based on the total amount (100 at%) of aluminum and zinc.

In a case where the second oxide layer 34 is made of GZO, the amount of gallium in the second oxide layer 34 is preferably from 0.5 to 10 at%, more preferably from 2 to 7 at% based on the total amount (100 at%) of gallium and zinc.

In a case where the second oxide layer 34 is made of ITO, the amount of tin in the second oxide layer 34 is preferably from 1 to 50 at%, more preferably from 5 to 40 at% based on the total amount (100 at%) of tin and indium.

A film formed of a simple substance of zinc oxide has a large internal stress. If the internal stress is large, cracks are likely to be formed in the second oxide layer 34, and moisture is likely to penetrate through such cracked portions. By controlling the amount of titanium to be at least 1 at%, by controlling the amount of aluminum to be at least 1 at% or by controlling the amount of gallium to be at least 0.5 at%, it is possible to reduce the internal stress of the second oxide layer 34 and thereby to minimize the possibility of cracking. Further, by controlling the amount of titanium to be at most 50 at%, by controlling the amount of aluminum to be at most 10 at% or by controlling the amount of gallium to be at most 10 at%, it is possible to maintain the crystal structure of zinc oxide.

The physical thickness of the second oxide layer 34 is preferably from 1 to 30 nm, more preferably from 5 to 20 nm.

In a case where at least two electromagnetic wave shielding films 100 are laminated, the thicknesses of the second oxide layers 34 in the respective electromagnetic wave shielding films 100 laminated may be all the same. Further, as a case requires, a second oxide layer 34 differing in the thickness from the other second oxide layers 34 may be included.

A method of forming the second oxide layer 34 may, for example, be physical vapor deposition such as vacuum vapor deposition, reactive vapor deposition, ion beam assisted vapor deposition, sputtering or ion plating or chemical vapor deposition such as plasma enhanced CVD. Among them, DC sputtering is preferred, since control of the thickness is thereby relatively easy, a practical film strength can be obtained even when it is formed on a low temperature substrate, a film formation over a large area is easy, or formation of a laminated film is easy if a so-called inline installation is employed.

(Electroconductive Layer)

The electroconductive layer 33 is a layer containing silver as the main component. The content of silver in the electroconductive layer 33 is preferably at least 90 at%, more preferably at least 95 at%, particularly preferably at least 99 at% in all metal atoms (100 at%) contained in the electroconductive layer 33. A material containing silver as the main component may be a simple substance of silver, or an alloy having at least one metal selected from palladium, platinum, gold, iridium, rhodium, copper and bismuth incorporated to silver. By controlling the silver content to be within the above range, it is-possible to lower the resistance of the electromagnetic wave shielding laminate 1 even if the thickness of the electroconductive layer 33 is made thin. Further, the resistance can be made low even if the number of lamination of the electromagnetic wave shielding films 100, is small, whereby it is possible to obtain an electromagnetic wave shielding laminate 1 which has a low resistance and a high visible light transmittance.

The electroconductive layer 33 is.preferably a layer made of a simple substance of silver, with a view to lowering the resistance of the electromagnetic wave shielding laminate 1. A simple substance of silver in the present invention means that silver is contained in an amount of at least 99.9 at% in the electroconductive layer 33 (100 at%).

With a view to suppressing migration of silver and thereby increasing the moisture resistance, the electroconductive layer 33 is preferably a layer made of a silver alloy containing gold and/or bismuth. The total amount of gold and bismuth is preferably from 0.2 to 1.5 at% in the electroconductive layer 33 (100 at%) in order that the resistivity is at most 4.5 $\mu\Omega$cm.

The total of physical thicknesses of all the electroconductive layers 33 in the electromagnetic wave shielding laminate 1 is, for example, in a case where the aimed resistance of the electroconductive laminate 10 to be obtained is 1.5 $\Omega/\square$, preferably from 25 to 60 nm, more preferably from 25 to 50 nm. In a case where the aimed: resistance is 1 $\Omega/\square$, it is preferably from 35 to 80 nm, more preferably from 35 to 70 nm. With respect to the physical thickness of each electroconductive layer 33, the total thickness is properly allocated among the respective electroconductive layers 33. Since the resistivities of the respective electroconductive layers increase as the number of the electroconductive layers 33, increases the total thickness tends to increase so as to lower the resistance.

The physical thickness of one electroconductive layer 33 is preferably from 5 to 20 nm. Physical thicknesses of the respective electroconductive layers 33 may be the same or different. Namely, in a case where at least two electromagnetic wave shielding films 30 are laminated, the thicknesses of the electroconductive layers 33 in the respective electromagnetic wave shielding films 100 laminated may be all the same. Further, as the case requires, an electroconductive layer 33 differing in the thickness from the other electroconductive layers 33 may be included.

Formation of the electroconductive layer may be carried out by various methods such as sputtering or vapor deposition. Formation by DC sputtering is particularly preferred, whereby the film forming speed is high, and a layer having a uniform thickness and a uniform quality can be formed over a large area.

The number of lamination of the electromagnetic wave shielding films 100 to be laminated on the substrate 2 is preferably at least 2 in order to provide sufficient electromagnetic wave shielding properties. When the lamination number is at least 2, sufficient electromagnetic wave shielding properties will be obtained. Further, it is more preferred that at least 3 such films are laminated. Further, it is preferred that the number of lamination of the electromagnetic wave shielding films 100 is preferably at most 8, whereby a high visible light transmittance can be maintained. From such a viewpoint, the lamination number is most preferably from 3 to 6.

(DISPLAY DEVICE)

FIRST EMBODIMENT

The display device may, for example, be a plasma display panel (PDP), a liquid crystal display device (LCD), an electroluminescence display (ELD), a cathode ray tube display (CRT) or a field emission display (FED).

In the display device, the observer side of the display screen to display images is usually constituted by a transparent board such as a glass board or a plastic board.

The display device of the present invention comprises a display screen to display images and an electromagnetic wave shielding laminate provided on the observer side of the display screen. The electromagnetic wave shielding laminate may be the electromagnetic wave shielding laminate of the present invention, and it may, for example, be the electromagnetic wave shielding laminate 1 shown in Fig. 1.

The electromagnetic wave shielding laminate may be bonded directly to the observer side surface of the display screen by means of e.g. an adhesive, or may be installed with a space from the display screen.

Otherwise, on the observer side of the display screen, a protective plate made of glass, plastic or the like may be installed afresh, and on the observer side or display side of the protective plate, the electromagnetic wave shielding laminate may be directly bonded. Or, on the observer side or display side of the protective plate, the electromagnetic wave shielding laminate may be installed with a space from the front plate.

Further, to the protective plate, an electroconductive mesh film may be bonded so as to increase electromagnetic wave shielding properties.

The electroconductive mesh film is one comprising a transparent film and an electroconductive mesh layer made of copper formed on the transparent film. Usually, it is produced by bonding a copper foil to a transparent film, and processing the laminate into a mesh.

The copper foil may be either rolled copper or electrolytic copper, and known one is used. The copper foil may be subjected to surface treatment. The surface treatment may, for example, be chromate treatment, surface roughening, acid wash or zinc chromate treatment. The thickness of the copper foil is preferably from 3 to 30 $\mu$m, more preferably from 5 to 20 $\mu$m, particularly preferably from 7 to 10 $\mu$m. When the thickness of the copper foil is at most 30 $\mu$m, the etching time can be shortened, and when it is at least 3 $\mu$m, high electromagnetic wave shielding properties will be achieved.

The open area of the electroconductive mesh layer is preferably from 60 to 95%, more preferably from 65 to 90%, particularly preferably from 70 to 85%.

The shape of the openings of the electroconductive mesh layer is an equilateral triangle, a square, an equilateral hexagon, a circle, a rectangle, a rhomboid or the like. The openings are preferably uniform in shape and aligned in a plane.

With respect to the size of the openings, one side or the diameter is preferably from 5 to 200 $\mu$m, more preferably from 10 to 150 $\mu$m. When one side or the diameter of the openings is at most 200 $\mu$m, electromagnetic wave shielding properties will improve, and when it is at least 5 $\mu$m, influences over an image of a display device will be small.

The width of a metal portion other than the openings is preferably from 5 to 50 $\mu$m. When the width of the metal portion is at least 5 $\mu$m, processing will be easy, and when it is at most 50 $\mu$m, influences over an image of a display device will be small.

That is, the mesh pitch of the openings is preferably from 10 to 250 $\mu$m.

If the sheet resistance of the electroconductive mesh layer is lower than necessary, the film tends to be thick, and such will adversely affect optical performance, etc. of the protective plate, such that no sufficient openings can be secured. On the other hand, if the sheet resistance of the electroconductive mesh layer is higher than necessary, no sufficient electromagnetic wave shielding properties will be obtained. Accordingly, the sheet resistance of the electroconductive mesh layer is preferably from 0..01 to 10 $\Omega/\square$, more preferably from 0.01 to 2 $\Omega/\square$, particularly preferably from 0.05 to 1 $\Omega/\square$.

The sheet resistance of the electroconductive mesh layer can be measured by a four-point probe method using electrodes at least five times larger than one side or the diameter of the opening with a distance between electrodes at least five times the mesh pitch of the openings. For example, when 100 $\mu$m square openings are regularly arranged with metal portions with a width of 20$\mu$m, the sheet resistance can be measured by arranging electrodes with a diameter of 1 mm with a distance of 1 mm. Otherwise, the electroconductive mesh film is processed into a stripe, electrodes are provided on both ends in the longitudinal direction to measure the resistance R therebetween thereby to determine the sheet resistance from the length a in the longitudinal direction and the length b in the lateral direction in accordance with the following formula:

$$\texttt{Sheet resistance = R} \times \texttt{b/a}$$

To laminate a copper foil on a transparent film, a transparent adhesive is used. The adhesive may, for example, be an acrylic adhesive, an epoxy adhesive, a urethane adhesive, a silicone adhesive or a polyester adhesive. As a type of the adhesive, a two-liquid type or a thermosetting type is preferred. Further, the adhesive is preferably one having excellent chemical resistance.

As a method of processing a copper foil into a mesh, a photoresist process may be mentioned. In the print process, the pattern of the openings is formed by screen printing. By the photoresist process, a photoresist material is formed on a copper foil by e.g. roll coating, spin coating, overall printing or transferring, followed by exposure, development and etching to form the pattern of the openings. As another method of forming the electroconductive mesh layer, a method of forming the pattern of the openings by the print process such as screen printing may be mentioned.

SECOND EMBODIMENT

The display device of the present invention may be constituted by a display screen to display images and an electromagnetic wave shielding film provided on the observer side surface of the display screen.

In such a case, a transparent board such as a glass board or a plastic board on the observer side of the display screen corresponds to a substrate of the electromagnetic wave shielding laminate of the present invention.

Such a display device may, for example, be:

(1) a display device wherein the electromagnetic wave shielding film has, sequentially from the observer side surface of the display screen, a first high refractive index layer made of a metal oxide having a refractive index of at least 2.0, a first oxide layer containing zinc oxide and titanium oxide as the main components, an electroconductive layer containing silver as the main component, and a second high refractive index layer made of a metal oxide having a refractive index of at least 2.0;

(2) a display device wherein such an electromagnetic wave shielding film has a second oxide layer between the electroconductive layer and the second high refractive index layer;

(3) a display device wherein the first or second high refractive index layer of such an electromagnetic wave shielding film is a layer containing niobium oxide or titanium oxide as the main component;

(4) a display device wherein the electroconductive layer of such an electromagnetic wave shielding film is a layer made of a silver alloy containing gold and/or bismuth or a layer made of a simple substance of silver; or

(5) a display device wherein at least three such electromagnetic wave shielding films are laminated from the substrate side.

Further, as such an electromagnetic wave shielding film, the electromagnetic wave shielding film 100 shown in Fig. 1 may, for example, be used. In such a case, on the observer side surface of the display screen, a first high refractive index layer 31, a first oxide layer 32, an electroconductive layer 33, a second oxide layer 34 and a second high refractive index layer 35 are laminated sequentially.

The electromagnetic wave shielding film may be formed directly on the observer side surface of the display screen by e.g. vapor deposition or sputtering.

EXAMPLES

EXAMPLE 1

First, the surface of a polyethylene terephthalate (PET) film with a thickness of 100 $\mu$m as a substrate 2 was cleaned by dry cleaning by ion beams. About 30% of oxygen was mixed with an argon gas, an electric power of 100 W was charged, and argon ions and oxygen ions ionized by an ion beam source were applied to the surface of the substrate 2.

The electromagnetic wave shielding laminate 1 shown in Fig. 1 was prepared by repeatedly carrying out the following operations (i) to (iv).

(i) Pulse sputtering was carried out using a niobium oxide target (NBO, manufactured by Asahi Glass Ceramics Co., Ltd.) under a pressure of 0.73 Pa, at a frequency of 50 kHz, at an electric power density of 4.5 W/cm$^2$ at a reverse pulse duration of 2 $\mu$sec, while introducing an argon gas with which 5 vol% of an oxygen gas was mixed, to form a first high refractive index layer 31(1) ((1) indicates a layer in the first electromagnetic wave shielding film 100 from the substrate 2 side, and hereinafter (2), (3) and (4) similarly indicate layers in the second, third and fourth electromagnetic wave shielding films) with a thickness of 20 nm on the surface of the substrate 2.

(ii) Pulse sputtering was carried out using a TZO target (zinc oxide:titanium oxide=85:15 (mass ratio)) under a pressure of 0.73 Pa, at a frequency of 50 kHz, at an electric power density of 0.34 W/cm$^2$ at a reverse pulse duration of 2 $\mu$sec while introducing an argon gas with which 15 vol% of an oxygen gas was mixed, to form a first oxide layer 32(1) with a thickness of 15 nm on the surface of the first high refractive index layer 31(1). As measured by ESCA5500 manufactured by ULVAC-PHI, Inc., in the first oxide layer 32(1), the amount of zinc was 85 at% and the amount of titanium was 15 at% based on the total amount (100 at%) of zinc and titanium.

(iii) Pulse sputtering was carried out using a silver alloy target doped with 1.0 mass% of gold under a pressure of 0.73 Pa, at a frequency of 50 kHz, at an electric power density of 2.3 W/cm$^2$ at a reverse pulse duration of 10 $\mu$sec while introducing an argon gas to form an electroconductive layer 33(1) with a thickness of 10 nm on the surface of the first oxide layer 32(1). As measured by ESCA5500 manufactured by ULVAC-PHI, Inc., in the electroconductive layer 33, the amount of silver is 99 at% based on all metal atoms (100 at%).

(iv) Pulse sputtering was carried out using a TZO target (zinc oxide:titanium oxide=85:15 (mass ratio)) under a pressure of 0.73 Pa, at a frequency of 50 kHz, at an electric power density of 0.34 W/cm$^2$ at a reverse pulse duration of 2 $\mu$sec while introducing an argon gas with which 2 vol% of an oxygen gas was mixed to form a second oxide layer 34(1) with a thickness of 15 nm on the surface of the electroconductive layer 33(1). As measured by ESCA5500 manufactured by ULVAC-PHI, Inc., in the second oxide layer 34(1), the amount of zinc was 85 at% and the amount of titanium was 15 at% based on the total amount (100 at%) of zinc and titanium. Further, proportions of zinc and titanium were measured by Rutherford back scattering spectroscopy (RBS) using Pelletron accelerator 3UH manufactured by National Electrostatics Corporation under the following conditions.

Beam energy: 2,300 keV
Ion species: He$^+$
Scattering angle: 170°, 100°
Incident beam angle: 7° to the normal of the sample surface
Current through sample: 30 nA
Dose of beam irradiation: 40 $\mu$C
As a result, in the second oxide layer 34(1), the amount of zinc was 85 at% and the amount of titanium was 15 at% based on the total amount (100 at%) of zinc and titanium.

In the same manner as in the above (i), a high refractive index layer 200 (a second high refractive index layer 35(1) and a first high refractive index layer 31(2)) with a thickness of 40 nm was formed on the surface of the second oxide layer 34(1).

In the same manner as in the above (ii), a first oxide layer 32(2) with a thickness of 15 nm was formed on the surface of the high refractive index layer 200.

In the same manner as in the above (iii), an electroconductive layer 33(2) with a thickness of 14 nm was formed on the surface of the first oxide layer 32 (2).

In the same manner as in the above (iv), a second oxide layer 34(2) with a thickness of 15 nm was formed on the surface of the electroconductive layer 33(2)

In the same manner as in the above (i), a high refractive index layer 200 (a second high refractive index layer 35(2) and a first high refractive index layer 31(3)) with a thickness of 40 nm was formed on the surface of the second oxide layer 34(2).

In the same manner as in the above (ii), a first oxide layer 32(3) with a thickness of 15 nm was formed on the surface of the high refractive index layer 200.

In the same manner as in the above (iii), an electroconductive layer 33(3) with a thickness of 14 nm was formed on the surface of the first oxide layer 32(3).

In the same manner as in the above (iv), a second oxide layer 34(3) with a thickness of 15 nm was formed on the surface of the electroconductive layer 33(3).

In the same manner as in the above (i), a high refractive index layer 200 (a second high refractive index layer 35(3) and a first high refractive index layer 31(4)) with a thickness of 40 nm was formed on the surface of the second oxide layer 34(3).

In the same manner as in the above (ii), a first oxide layer 32(4) with a thickness of 15 nm was formed on the surface of the high refractive index layer 200.

In the same manner as in the above (iii), an electroconductive layer 33(4) with a thickness of 10 nm was formed on the surface of the first oxide layer 32(4).

In the same manner as in the above (iv), a second oxide layer 34(4) with a thickness of 15 nm was formed on the surface of the electroconductive layer 33(4).

In the same manner as in the above (i), a second high refractive index layer 35(4) with a thickness of 20 nm was formed on the surface of the second oxide layer (4).

Of the electromagnetic wave shielding laminate 1 thus prepared, the luminous transmittance (stimulus Y stipulated in JIS Z 8701) measured by color analyzer TC1800 manufactured by Tokyo Denshoku Co., Ltd. was 69.6%, and the sheet resistance (surface resistance) measured by eddy current type resistance measuring apparatus SRM12 manufactured by Nagy was 1.011 $\Omega/\square$. Further, the moisture resistance was evaluated as follows.

A NaCl test was used for evaluation of the moisture resistance. First, 1 $\mu$L of a 2 mass% NaCl aqueous solution was dropped on the electromagnetic wave shielding film 100 of the electromagnetic wave shielding laminate 1 and then dried. Thereafter, a PET film (thickness: 100 $\mu$m) provided with an adhesive material (ADC2 manufactured by Polatechno Co., Ltd. or PTR2500 manufactured by Arisawa Mfg. Co., Ltd., thickness: 25 $\mu$m) was bonded on the electromagnetic wave shielding film 100, followed by storage for 100 hours in a constant temperature and humidity tank at a temperature of 60°C with a relative humidity of 90%, whereupon the assembly was taken out, and the PET film was peeled. The area of the portion which was deteriorated and peeled (the deteriorated area) was measured by a slide gauge. The results are shown in Table 1.

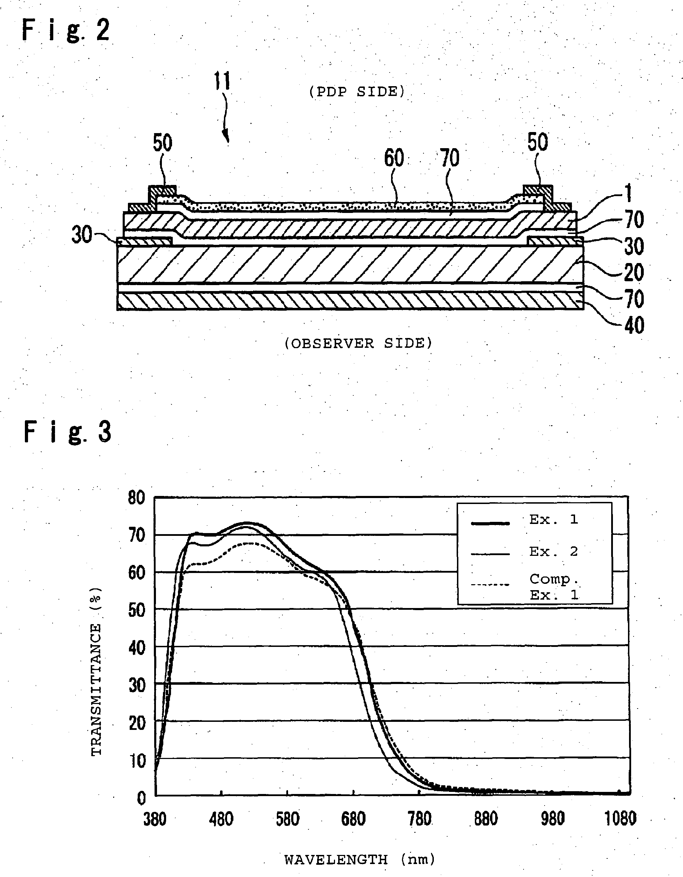

A protective plate 11 for a PDP shown in Fig. 2 was prepared as follows.

First, an adhesive layer 70 (acrylic adhesive, thickness: 25 $\mu$m) was provided on the substrate 2 side surface of the electromagnetic wave shielding laminate 1.

A glass plate as a support 20 was cut into a predetermined size, chamfered and cleaned, and an ink for a color ceramic layer was applied to the periphery of the glass plate by screen printing and sufficiently dried to form a color ceramic layer 30. Then, the support 20 on which the color ceramic layer 30 was formed was heated to 660°C and then air cooled to apply glass tempering treatment.

The electromagnetic wave shielding laminate 1 was bonded on the color ceramic layer 30 side of the support 20 via the above adhesive layer 70. Then, for the purpose of protecting the electromagnetic wave shielding laminate 1, a protective film 60 (ARCTOP CP21, tradename, manufactured by Asahi Glass Company, Limited, thickness: 100 $\mu$m) was bonded on the surface of the electromagnetic wave shielding laminate 1 via an adhesive layer 70 (acrylic adhesive, thickness: 25 $\mu$m). Here, for the purpose of forming electrodes, a portion (electrode formation portion) on which no protective film 60 was bonded was left at the peripheral portion of the electromagnetic wave shielding laminate 1.

Then, on the electrode formation portion, a.silver paste (AF4810, tradename, manufactured by TAIYO INK MFG. CO., LTD.) was applied by screen printing with a nylon mesh #180 with an emulsion thickness of 20 $\mu$m, followed by drying in a circulating hot air oven at 85°C for 35 minutes to form an electrode 50.

Then, on the back side of the support 20 (a side opposite to the side where the electroconductive laminate 10 was bonded), a polyurethane flexible resin film (ARCTOP URP2199, tradename, manufactured by Asahi Glass Company, Limited, thickness: 300 $\mu$m) as a shatterproof film 40 was bonded via an adhesive layer 70 (acrylic adhesive, thickness: 25 $\mu$m). The polyurethane flexible resin film also has an antireflection function. Usually, a coloring agent is added to the polyurethane flexible resin film to impart color tone correction function and Ne beam cut function to improve color reproducibility. However, in this Example, the resin film was not colored since no evaluation of the color tone correction and the Ne beam cut was carried out.

Of the protective plate 11 for a PDP thus prepared, the luminous transmittance (stimulus Y stipulated in JIS Z 8701) measured by color analyzer TC1800 manufactured by Tokyo Denshoku Co., Ltd. from the observer side in Fig. 2 was 68.8%. Further, the transmittance at a wavelength of 850 nm was 1.0%. The transmission spectrum of the protective plate 11 for a PDP is shown in Fig. 3.

EXAMPLE 2

An electromagnetic wave shielding laminate 1 was prepared in the same manner as in Example 1 except that the thickness of the first high refractive index layer 31 was changed to 10 nm, the thickness of the first oxide layer 32 to 25 nm, the thickness of the second oxide layer 34 to 25 nm, the thickness of the second high refractive index layer 35 to 10 nm, and the thickness of the high refractive index layer 200 (the second high refractive index layer 35 + the first high refractive index layer 31) to 20 nm.

Of the electromagnetic wave shielding laminate 1 in Example 2, the luminous transmittance (stimulus Y stipulated in JIS Z 8701) measured by color analyzer TC1800 manufactured by Tokyo Denshoku Co., Ltd. was 67.7%, and the sheet resistance (surface resistance) measured by eddy current type resistance measuring apparatus SRM12 manufactured by Nagy was 1.005 $\Omega$/□. Further, the moisture resistance was evaluated. The results are shown in Table 1.

Further, a protective plate 11 for a PDP shown in Fig. 2 was prepared in the same manner as in Example 1 except that the electromagnetic wave shielding laminate 1 in Example 2 was used.

Of the protective plate-11 for a PDP in Example 2, the luminous transmittance (stimulus Y stipulated in JIS Z 8701) measured by color analyzer TC1800 manufactured by Tokyo Denshoku Co., Ltd. from the observer side in Fig. 2 was 67.0%. Further, the transmittance at a wavelength of 850 nm was 0.7%. The transmission spectrum of the protective plate 11 for a PDP is shown in Fig. 3.

COMPARATIVE EXAMPLE 1

An electromagnetic wave shielding laminate was prepared in the same manner as in Example 1 except that no first oxide layer 32 was formed and the electroconductive layer 33 was formed directly on the surface of the first high refractive index layer 31 or the high refractive index layer 200, and that the thickness of the first high refractive index layer 31(1) in the first electromagnetic wave shielding film was changed to 35 nm, the thickness of the second oxide layer 34 in the second electromagnetic wave shielding film 100 to 5 nm, the thickness of the second high refractive index layer 35(4) in the fourth electromagnetic wave shielding film to 30 nm, and the thickness of the high refractive index layer 200 (the second high refractive index layer 35 and the first high refractive index layer 31) to 55 nm.

Of the electromagnetic wave shielding laminate in Comparative Example 1, the luminous transmittance (stimulus Y stipulated in JIS Z 8701) measured by color analyzer TC1800 manufactured by Tokyo Denshoku Co., Ltd. was 65.6%, and the sheet resistance (surface resistance) measured by eddy current type resistance measuring apparatus SRM12 manufactured by Nagy was 1.163 $\Omega$/□. Further, the moisture resistance was evaluated. The results are.shown in Table 1.

Further, a protective plate for a PDP shown in Fig. 2 was prepared in the same manner as in Example 1 except that the electromagnetic wave shielding laminate in Comparative Example 1 was used.

Of the protective plate for a PDP in Comparative Example 1, the luminous transmittance (stimulus Y stipulated in JIS Z 8701) measured by color analyzer TC1800 manufactured by Tokyo Denshoku Co., Ltd. from the observer side was 64.4%. Further, the transmittance at a wavelength of 850 nm was 1.1%. The transmission spectrum of the protective plate for a PDP is shown in Fig. 3.

TABLE 1

| | Electromagnetic wave shielding laminate | | | Protective plate for PDP | |
|---|---|---|---|---|---|
| | Luminous transmittance (%) | Surface resistance ($\Omega$) | Deteriorated area (mm$^2$) | Luminous transmittance (%) | Transmittance at a wavelength of 850 nm (%) |
| Ex. 1 | 69.6 | 1.011 | 16.2 | 68.8 | 1.0 |
| Ex. 2 | 67.7 | 1.005 | 15.0 | 67.0 | 0.7 |
| Comp.. Ex. 1 | 65.6 | 1.163 | 27.4 | 64.4 | 1.1. |

INDUSTRIAL APPLICABILITY

The electromagnetic wave shielding laminate of the present invention is useful as a filter for a display device, etc.

The entire disclosure of Japanese Patent Application No. 2005-050720 filed on February 25, 2005 including specification, claims, drawings and summary is incorporated herein by reference in its entirety.

**Claims**

1. An electromagnetic wave shielding laminate comprising a transparent substrate and an electromagnetic wave shielding film formed on the substrate, wherein the electromagnetic wave shielding film has, sequentially from the substrate side, a first high refractive index layer made of a metal oxide having a refractive index of at least 2.0, a first oxide layer containing zinc oxide and titanium oxide as the main components, an electroconductive layer containing silver as the main component and a second high refractive index layer made of a metal oxide having a refractive index of at least 2.0.

2. The electromagnetic wave shielding laminate according to Claim 1, wherein the electromagnetic wave shielding film has a second oxide layer between the electroconductive layer and the second high refractive index layer.

3. The electromagnetic wave shielding laminate according to Claim 2, wherein the second oxide layer is a layer containing zinc oxide as the main component, a layer containing indium oxide and tin oxide as the main components, a layer containing indium oxide and cerium oxide as the main components or a layer containing tin oxide as the main component.

4. The electromagnetic wave shielding laminate according to Claim 1, 2 or 3-, wherein at least one of the first and second high refractive index layers is a layer containing niobium oxide or titanium oxide as the main component.

5. The electromagnetic wave shielding laminate according to any one of Claims 1 to 4, wherein the electroconductive layer is a layer made of a silver alloy containing gold and/or bismuth or a layer made of a simple substance of silver.

6. The electromagnetic wave shielding laminate according to any one of Claims 1 to 5, wherein at least three such electromagnetic wave shielding layers are laminated from the substrate side.

7. An electromagnetic wave shielding laminate comprising a transparent substrate and at least two electromagnetic wave shielding films laminated on the substrate, wherein each of the electromagnetic wave shielding films has, sequentially from the substrate side, a first high refractive index layer made of a metal oxide having a refractive index of at least 2.0, a first oxide layer containing zinc oxide and titanium oxide as the main components, an electroconductive layer containing silver as the main component and a second high refractive index layer made of a metal oxide having a refractive index of at least 2.0, the first high refractive index layer and the second high refractive index layer have the same composition, and the first high refractive index layer and the second high refractive index layer in direct contact with each other of adjacent electromagnetic wave shielding films form a single uniform layer.

8. The electromagnetic wave shielding laminate according to Claim 7, wherein each of the electromagnetic wave shielding films has a second oxide layer between the electroconductive layer and the second high refractive index layer.

9. The electromagnetic wave shielding laminate according to Claim 7 or 8, wherein at least one of the first and second high refractive index layers is a layer containing niobium oxide or titanium oxide as the main component.

10. A display device comprising a display screen to display images, and the electromagnetic wave shielding laminate as defined in any one of Claims 1 to 9 provided on the observer side of the display screen.

# F i g. 1

# Fig. 2

11

(PDP SIDE)

(OBSERVER SIDE)

# Fig. 3

WAVELENGTH (nm)

<br>

**INTERNATIONAL SEARCH REPORT**

| International application No. |
|---|
| PCT/JP2006/303318 |

A. CLASSIFICATION OF SUBJECT MATTER
**H05K9/00**(2006.01), **B32B9/00**(2006.01)**, G9F9/00**(2006.01)

According to International Patent Classification (IPC) or to both national classification and IPC

B. FIELDS SEARCHED

Minimum documentation searched (classification system followed by classification symbols)
H05K9/00, B32B9/00, G09F9/00

Documentation searched other than minimum documentation to the extent that such documents are included in the fields searched
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2004-207383 A (Central Glass Co., Ltd.), 22 July, 2004 (22.07.04), Par. Nos. [0001], [0010], [0013], [0051]; Fig. 1 (Family: none) | 1-10 |
| Y | JP 2000-105311 A (Nitto Denko Corp.), 11 April, 2000 (11.04.00), Par. Nos. [0012], [0013] (Family: none) | 1-10 |
| Y | JP 2003-58064 A (Asahi Glass Co., Ltd.), 28 February, 2003 (28.02.03), Par. No. [0024] & US 2003/0085649 A1 & EP 1280179 A2 & CN 1399304 A & TW 554371 B | 2,3,8-10 |

[X] Further documents are listed in the continuation of Box C.    [ ] See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search 21 April, 2006 (21.04.06) | Date of mailing of the international search report 02 May, 2006 (02.05.06) |
| Name and mailing address of the ISA/ Japanese Patent Office | Authorized officer |
| Facsimile No. | Telephone No. |

Form PCT/ISA/210 (second sheet) (April 2005)

**INTERNATIONAL SEARCH REPORT**

International application No.

PCT/JP2006/303318

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2004-128220 A  (Central Glass Co., Ltd.),<br>22 April, 2004 (22.04.04),<br>Full text; Fig. 1<br>& WO 03/037056 A1 | 1-10 |
| A | JP 2002-3244 A  (Central Glass Co., Ltd.),<br>09 January, 2002 (09.01.02),<br>Full text<br>(Family: none) | 1-10 |
| A | JP 2002-535713 A  (Viratec Thin Films, Inc.),<br>22 October, 2002 (22.10.02),<br>Full text; Figs. 1 to 8<br>& US 2002/0075203 A1    & US 6353501 B1<br>& US 6490091 B1         & WO 00/043711 A1<br>& AU 2855000 A          & CZ 20012666 A | 1-10 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 981385 A
- JP 2000246831 A
- KR 200393734
- JP 2005050720 A